(19) Europäisches Patentamt / European Patent Office / Office européen des brevets

(11) **EP 4 787 470 A1**

(12) **EUROPEAN PATENT APPLICATION**
published in accordance with Art. 153(4) EPC

(43) Date of publication:
**05.08.2026 Bulletin 2026/32**

(21) Application number: **24886431.6**

(22) Date of filing: **31.10.2024**

(51) International Patent Classification (IPC):
$H01M\ 4/36^{(2006.01)}$    $H01M\ 4/525^{(2010.01)}$
$H01M\ 4/505^{(2010.01)}$    $C01G\ 53/00^{(2025.01)}$
$H01M\ 4/131^{(2010.01)}$    $H01M\ 10/052^{(2010.01)}$
$H01M\ 4/02^{(2006.01)}$

(52) Cooperative Patent Classification (CPC):
C01G 53/00; C30B 29/22; H01M 4/02; H01M 4/131;
H01M 4/36; H01M 4/505; H01M 4/525;
H01M 10/052; Y02E 60/10

(86) International application number:
**PCT/KR2024/096452**

(87) International publication number:
**WO 2025/095762 (08.05.2025 Gazette 2025/19)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **03.11.2023 KR 20230151121**

(71) Applicant: **LG Chem, Ltd.**
**Seoul 07336 (KR)**

(72) Inventors:
• **LIM, Seung Woo**
  **Daejeon 34122 (KR)**
• **SHIN, Ji A**
  **Daejeon 34122 (KR)**
• **HEO, Un Seon**
  **Daejeon 34122 (KR)**
• **LEE, Jee Ho**
  **Daejeon 34122 (KR)**
• **KIM, Sun Cheol**
  **Daejeon 34122 (KR)**
• **SHIN, Ye Won**
  **Daejeon 34122 (KR)**
• **YOU, Min Kyu**
  **Daejeon 34122 (KR)**

(74) Representative: **Hoffmann Eitle**
**Patent- und Rechtsanwälte PartmbB**
**Arabellastraße 30**
**81925 München (DE)**

(54) **CATHODE ACTIVE MATERIAL, METHOD FOR PREPARING SAME, AND CATHODE AND LITHIUM SECONDARY BATTERY COMPRISING SAME**

(57) The present invention relates to a positive electrode active material including a lithium composite transition metal oxide in the form of a single particle formed of 10 or fewer primary particles, having a composition represented by Formula 1 described herein, and a coating layer including a coating element (M) formed on the lithium composite transition metal oxide, wherein the coating element (M) is at least one selected from Al, W, Cu, Zr, Ni, Co, Sr, Mn, Y, Ti, Mg, Mo, B, Sn, Fe, Zn, and Si, and a single particle formation degree ($\chi$) is greater than 0.5 according to Equation 1 described herein, a method for preparing the same, and a positive electrode and a lithium secondary battery which include the same.

[FIG. 1]

**Description**

## TECHNICAL FIELD

### Cross-reference to Related Applications

The present application claims the benefit of the priority of Korean Patent Application No. 10-2023-0151121, filed on November 3, 2023, which is hereby incorporated by reference in its entirety.

### Technical Field

The present invention relates to a positive electrode active material, a method for preparing the same, and a positive electrode and a lithium secondary battery which include the same.

## BACKGROUND ART

Demand for secondary batteries as an energy source is on a rapid rise, resulting from technology development and a growing demand for mobile devices. Among such secondary batteries, lithium secondary batteries exhibiting high energy density and voltage, long cycle life, and low self-discharging rate have been commercially available and widely used.

Lithium composite transition metal oxides have been used as a positive electrode active material of the lithium secondary battery, and in particular, a lithium cobalt composite metal oxide, such as $LiCoO_2$, exhibiting a high working voltage and superior capacity characteristics has been primarily used. However, $LiCoO_2$ has fairly poor thermal properties due to an unstable crystal structure caused by delithiation and is also high-priced, and accordingly, has a limitation in being used as a power source in an area such as electric vehicles in a large amount.

Lithium manganese composite metal oxides ($LiMnO_2$, $LiMn_2O_4$, or the like), lithium iron phosphate compounds ($LiFePO_4$ or the like), or lithium nickel composite metal oxides ($LiNiO_2$ or the like) have been developed as materials for replacing $LiCoO_2$. Among these materials, research and development of the lithium nickel composite metal oxides, in which large capacity batteries are easily achieved due to a high reversible capacity of about 200 mAh/g, have been more actively conducted. However, $LiNiO_2$ has poorer thermal stability than $LiCoO_2$ and when an internal short circuit takes place in a charged state due to an external pressure, a positive electrode active material itself is decomposed to cause rupture and ignition of batteries.

Accordingly, as a method for retaining the superior reversible capacity of $LiNiO_2$ and mitigating the low thermal stability thereof, a nickel cobalt manganese-based lithium composite transition metal oxide, in which a portion of Ni is substituted with Mn and Co, a nickel manganese aluminum-based lithium composite transition metal oxide, and the like have been developed.

Meanwhile, a lithium composite transition metal oxide having a high content of nickel exhibits further degradation in structural and chemical stability, presents greater challenges in achieving thermal stability, and incurs higher costs due to the need for high-temperature processing. To enhance stability, extensive research has been undertaken, such as including doping elements in lithium composite transition metal oxides.

Therefore, there is a need to develop positive electrode active materials with improved stability and high nickel content, allowing for lithium secondary batteries exhibiting enhanced capacity and lifespan characteristics.

[Prior Art Documents]

[Patent Document]

(Patent Document 1) Korean Patent Application Publication No. 10-2021-0007808

## DISCLOSURE OF THE INVENTION

### TECHNICAL PROBLEM

The present invention is designed to overcome the limitations described above, and thus, an aspect of the present invention provides a positive electrode active material capable of enhancing battery capacity and lifespan characteristics and a method for preparing the same.

Another aspect of the present invention provides a positive electrode and a lithium secondary battery exhibiting superior capacity and lifespan characteristics, including the positive electrode active material.

## TECHNICAL SOLUTION

(1)According to an aspect of the present invention, provided is a positive electrode active material including a lithium composite transition metal oxide in the form of a single particle formed of 10 or fewer primary particles, having a composition represented by Formula 1 below, and a coating layer including a coating element (M) formed on the lithium composite transition metal oxide, wherein the coating element (M) is at least one selected from Al, W, Cu, Zr, Ni, Co, Sr, Mn, Y, Ti, Mg, Mo, B, Sn, Fe, Zn, and Si, and a single particle formation degree ($\chi$) is greater than 0.5 according to Equation 1 below.

$$[\text{Formula 1}] \qquad Li_{1+x}Ni_aCo_bMn_cM^1_dO_2$$

In Formula 1 above, $M^1$ is at least one selected from Zr, Y, W, Cu, Sr, Mn, Ti, Mg, Mo, B, Sn, Fe, Zn, Si, and Al, x, a, b, c, and d satisfy $-0.1 \leq x \leq 0.1$, $0.6 \leq a < 1$, $0 < b < 0.4$, $0 < c < 0.4$, $0 \leq d \leq 0.1$, $a+b+c+d=1$, and $0.25 \leq a-c \leq 0.45$, and

$$[\text{Equation 1}]$$

$$\chi = \frac{\text{Average particle size of primary particle } (D'_{50}) \, [\mu m]}{\text{Average particle size of positive electrode active material } (D_{50}) \, [\mu m]}.$$

(2) The present invention provides the positive electrode active material according to (1) above, wherein in Formula 1 above, a ranges from 0.6 to 0.75.

(3) The present invention provides the positive electrode active material according to (1) or (2) above, wherein in Formula 1 above, a-c satisfies $0.25 < a-c < 0.34$.

(4) The present invention provides the positive electrode active material according to any one of (1) to (3) above, wherein the coating layer contains the coating element (M) in an amount of 3000 ppm to 5500 ppm with respect to a total weight of the lithium composite transition metal oxide.

(5) The present invention provides the positive electrode material according to any one of (1) to (4) above, wherein the coating layer includes a Li-M-O compound, and M is at least one selected from Al, W, Cu, Zr, Ni, Co, Sr, Mn, Y, Ti, Mg, Mo, B, Sn, Fe, Zn, and Si.

(6) The present invention provides the positive electrode active material according to any one of (1) to (5) above, wherein the coating element (M) is at least one selected from Al and W.

(7) The present invention provides the positive electrode active material according to any one of (1) to (6) above, wherein the primary particles have an average particle size ($D'_{50}$) of 2 $\mu$m to 5 $\mu$m.

(8) The present invention provides the positive electrode active material according to any one of (1) to (7) above, wherein the positive electrode active material has an average particle size ($D_{50}$) of 3 $\mu$m to 5 $\mu$m.

(9) The present invention provides the positive electrode active material according to any one of (1) to (8) above, wherein the single particle formation degree ($\chi$) ranges from 0.6 to 0.9.

(10) According to another aspect of the present invention, provided is a method for preparing the positive electrode active material according to (1) above, including (A) mixing and firing a composite transition metal hydroxide and a lithium (Li)-containing raw material to prepare a lithium composite transition metal oxide, and (B) mixing the lithium composite transition metal oxide and a coating element (M)-containing raw material and then heat treating the mixture to form a coating layer, wherein the firing is performed at a temperature of 800 °C to 1100 °C, and the coating element (M) is at least one selected from Al, W, Cu, Zr, Ni, Co, Sr, Mn, Y, Ti, Mg, Mo, B, Sn, Fe, Zn, and Si.

(11) The present invention provides the method according to (10) above, wherein the coating element (M)-containing raw material is at least one selected from oxide, carbonate, nitrate, hydroxide, oxyhydroxide, and halide, containing the coating element (M).

(12) The present invention provides the method according to (10) or (11) above, wherein the coating element (M)-containing raw material is mixed to achieve the coating element (M) in an amount of 3000 ppm to 5500 ppm with respect to a total weight of the lithium composite transition metal oxide.

(13) The present invention provides the method according to any one of (10) to (12) above, wherein the heat treatment is performed at a temperature of 400 °C to 600 °C.

(14) According to another aspect of the present invention, provided is a positive electrode including the positive electrode active material according to any one of (1) to (9) above.

(15) According to another aspect of the present invention, provided is a lithium secondary battery including the positive electrode according to (14) above.

**ADVANTAGEOUS EFFECTS**

A positive electrode active material according to the present invention includes a lithium composite transition metal oxide having a mole fraction difference between nickel and manganese within a specific range, and a coating layer formed on the lithium composite transition metal oxide, and may thus maintain electrode density by regulating an average particle size of primary particles, reduce side reactions with an electrolyte, and improve electrical conductivity. Accordingly, a positive electrode and a secondary battery which include the positive electrode active material achieve enhanced capacity characteristics and lifespan characteristics.

In addition, according to a method for preparing a positive electrode active material of the present invention, the positive electrode active material described above may be effectively prepared.

**BRIEF DESCRIPTION OF THE DRAWINGS**

FIG. 1 is an SEM image (magnification: 5 K) showing a positive electrode active material prepared in Example 1;
FIG. 2 is an SEM image (magnification: 5 K) showing a positive electrode active material prepared in Example 2;
FIG. 3 is an SEM image (magnification: 5 K) showing a positive electrode active material prepared in Comparative Example 1;
FIG. 4 is an SEM image (magnification: 5 K) showing a positive electrode active material prepared in Comparative Example 3;
FIG. 5 is an SEM image (magnification: 20 K) showing a positive electrode active material prepared in Example 1; and
FIG. 6 is an SEM image (magnification: 50 K) showing a positive electrode active material prepared in Example 1.

**BEST MODE FOR CARRYING OUT THE INVENTION**

Hereinafter, the present invention will be described in detail to aid in understanding of the present invention.

It will be understood that words or terms used in the specification and claims shall not be interpreted as the meaning defined in commonly used dictionaries, and it will be further understood that the words or terms should be interpreted as having a meaning that is consistent with their meaning in the context of the relevant art and the technical idea of the invention, based on the principle that an inventor may properly define the meaning of the words or terms to best explain the invention.

Herein, it will be further understood that the terms 'include', 'comprise', or 'have' specify the presence of stated features, numbers, steps, elements, or combinations thereof, but do not preclude the presence or addition of one or more other features, numbers, steps, elements, or combinations thereof.

Herein, the term 'on' indicates a case in which a certain component is formed directly on an upper surface of another component, and also a case in which a third component is interposed between these components.

Herein, a 'single particle form' is a concept in contrast to a spherical secondary particle form, in which tens to hundreds of primary particles are aggregated, formed through typical methods, and indicates a form made up of 10 or fewer primary particles. Specifically, the single particle form herein may be in the form of a single particle formed of one primary particle or in the form of a secondary particle in which 2 to 10 primary particles are aggregated.

Herein, a 'primary particle' indicates a smallest unit of particles recognized when observing a positive electrode active material through a scanning electron microscope (SEM), and a 'secondary particle' indicates a secondary structure where a plurality of primary particles are aggregated.

Herein, the content of each element in a lithium composite transition metal oxide may be measured through inductive coupled plasma (ICP) analysis using an inductively coupled plasma optical emission spectrometer (ICP-OES; Optima 7300DV, PerkinElmer).

Herein, a particle size of primary particles may be determined by calculating an area of each primary particle based on the number of pixels corresponding to each of the n primary particles present in an SEM image and measuring a particle size of each primary particle present in the SEM image using the diameter of a circle having the same area as each primary particle. In addition, herein, an average particle size ($D'_{50}$) of primary particles may be defined as a particle size at a cumulative volume distribution of 50% in a particle size distribution curve (curve on the graph of a particle size distribution) of each particle. The average particle size ($D'_{50}$) of primary particles may be determined by calculating a particle diameter at 50% of the cumulative distribution of volume according to the particle size from the results of calculating volume of the primary particle, which is defined by the volume of a sphere whose radius is half of the particle size of the primary particle.

Herein, an average particle size $D_{50}$ of a positive electrode active material may be defined as a particle size at a cumulative volume distribution of 50% in a particle size distribution curve (curve on the graph of a particle size distribution) of each particle. After dispersing measurement target powder in a dispersion medium, the dispersion medium is introduced into a commercial laser diffraction particle size measurement instrument (e.g., S3500 from Microtrac), a particle size distribution is calculated by measuring a difference in diffraction patterns due to a particle size when particles pass through a laser beam, and a particle diameter at 50% of the cumulative distribution of volume according to the particle size using the measurement instrument is calculated to determine the average particle size ($D_{50}$) of the positive electrode active material.

**Positive electrode active material**

Hereinafter, a positive electrode active material according to the present invention will be described.

The positive electrode active material according to the present invention includes a lithium composite transition metal oxide in the form of a single particle formed of Positive electrode active material layer 10 or fewer primary particles, having a composition represented by Formula 1 below, and a coating layer including a coating element (M) formed on the lithium composite transition metal oxide, wherein the coating element (M) is at least one selected from Al, W, Cu, Zr, Ni, Co, Sr, Mn, Y, Ti, Mg, Mo, B, Sn, Fe, Zn, and Si, and a single particle formation degree ($\chi$) is greater than 0.5 according to Equation 1 below.

$$[Formula\ 1] \qquad Li_{1+x}Ni_aCo_bMn_cM^1_dO_2$$

In Formula 1 above,

$M^1$ is at least one selected from Zr, Y, W, Cu, Sr, Mn, Ti, Mg, Mo, B, Sn, Fe, Zn, Si, and Al, x, a, b, c, and d satisfy $-0.1 \leq x \leq 0.1$, $0.6 \leq a < 1$, $0 < b < 0.4$, $0 < c < 0.4$, $0 \leq d \leq 0.1$, $a+b+c+d=1$, and $0.25 \leq a-c \leq 0.45$, and

$$[Equation\ 1]$$

$$\chi = \frac{Average\ particle\ size\ of\ primary\ particle\ (D'_{50})\ [\mu m]}{Average\ particle\ size\ of\ positive\ electrode\ active\ material\ (D_{50})\ [\mu m]}.$$

The present inventors have found that when a positive electrode active material having a difference in mole fraction of nickel and manganese contained in a lithium composite transition metal oxide having a high nickel content within a specific range, including a coating layer containing a coating element (M) formed on a lithium composite transition metal oxide, and having a single particle formation degree within a specific range is included, a lithium secondary battery exhibiting improved capacity characteristics and lifespan characteristics is achievable. Specifically, an average particle size of primary particles of the lithium composite transition metal oxide is determined by the difference in mole fraction of nickel and manganese. When the average particle size of primary particles increases, electrode density decreases and side reactions with an electrolyte decreases, and when the average particle size of primary particles decreases, electrode density increases and side reactions with an electrolyte increases. In addition, by including the coating layer formed on the lithium composite transition metal oxide, electrical conductivity may be improved and byproducts formed through side reactions with an electrolyte may be controlled. The inventors have found that the positive electrode active material includes a coating layer containing a lithium composite transition metal oxide having a difference in mole fraction of nickel and manganese within a specific range and a coating element (M) formed on the lithium composite transition metal oxide, thereby appropriately controlling the average particle size ($D'_{50}$) of primary particles of the positive electrode active material, and thus when the degree of single particle formation according to Equation 1 described herein is within a specific range, the capacity characteristics, resistance characteristics, and lifespan characteristics of the positive electrode active material may be improved, thereby completing the invention.

Meanwhile, when the difference in mole fraction of nickel and manganese contained in the lithium composite transition metal oxide having a high nickel content was not within a specific range or the degree of single particle formation was 0.5 or less, the average particle size ($D'_{50}$) of primary particles of the lithium composite transition metal oxide was small, and accordingly, lifespan characteristics were damaged, or when rolling for electrode manufacturing or cell operation, particle breakage took place due to grain boundaries, an grain boundary area in contact with an electrolyte increased significantly, and gas generation caused by side reactions with the electrolyte increased, resulting in poor lifespan characteristics and resistance characteristics. In addition, when the coating layer including the coating element (M) formed on the lithium composite transition metal oxide having a high nickel content was not included, electrical conductivity was inferior, and capacity characteristics, resistance characteristics, and lifespan characteristics were degraded due to byproducts formed by side reactions with an electrolyte.

The lithium composite transition metal oxide is in the form of a single particle composed of 10 or fewer primary particles. That is, the lithium composite transition metal oxide is in the form of a one-body particle or a single particle in which 2 to 10 particles are aggregated. The single particle form is distinct from a secondary particle in which more than 10 primary particles are aggregated. When in the form of a single particle, the lithium composite transition metal oxide exhibits superior stability. Thus, a positive electrode active material including the lithium composite transition metal oxide, even when rolled, is prevented from breakage or cracks, and accordingly, side reactions between the positive electrode active material and an electrolyte may be reduced. Consequently, batteries may have improved durability against volume changes during charge and discharge, resulting in enhanced lifespan characteristics. When the lithium composite transition metal oxide was in the form of a secondary particle form, upon rolling the positive electrode active material containing the lithium composite transition metal oxide, the positive electrode active material was broken or cracked, causing a side reaction between the positive electrode active material and the electrolyte, resulting in poor durability against volume changes during charge and discharge of batteries and poor lifespan characteristics.

$M^1$ is a doping element, and specifically, $M^1$ may be at least one selected from Zr, Y, W, Cu, Sr, Mn, Ti, Mg, Mo, B, Sn, Fe, Zn, Si, and Al. M1 is not necessarily included, but when included in an appropriate amount, the positive electrode active material may exhibit improved particle shape and enhanced crystal structure stability.

Meanwhile, x may be -0.1 or greater, -0.09 or greater, -0.08 or greater, -0.07 or greater, -0.06 or greater, -0.05 or greater, -0.04 or greater, -0.03 or greater, -0.02 or greater, -0.01 or greater, 0 or greater, 0.01 or greater, 0.02 or greater, or 0.03 or greater, and may be 0.04 or less, 0.05 or less, 0.06 or less, 0.07 or less, 0.08 or less, 0.09 or less, or 0.1 or less. When x satisfies the above range, high capacity characteristics and high energy density per unit volume may be achieved.

a is a mole fraction of nickel (Ni) among all metals excluding lithium in the lithium composite transition metal oxide, and may be 0.6 or greater, 0.61 or greater, 0.62 or greater, 0.63 or greater, or 0.64 or greater, and may be 0.65 or less, 0.66 or less, 0.67 or less, 0.68 or less, 0.69 or less, 0.7 or less, 0.71 or less, 0.72 or less, 0.73 or less, 0.74 or less, 0.75 or less, 0.76 or less, 0.77 or less, 0.78 or less, 0.79 or less, 0.8 or less, 0.81 or less, 0.82 or less, 0.83 or less, 0.84 or less, 0.85 or less, 0.86 or less, 0.87 or less, 0.88 or less, 0.89 or less, 0.9 or less, 0.91 or less, 0.92 or less, 0.93 or less, 0.94 or less, 0.95 or less, 0.96 or less, 0.97 or less, 0.98 or less, 0.99 or less, or less than 1. High-capacity characteristics may be achieved, and in particular, when a is 0.6 to 0.75, high-capacity characteristics may be achieved due to high energy density shown under high-voltage driving.

b is a mole fraction of cobalt (Co) among all metals excluding lithium in the lithium composite transition metal oxide, and may be greater than 0, 0.01 or greater, 0.02 or greater, 0.03 or greater, 0.04 or greater, 0.05 or greater, or 0.06 or greater, and may be 0.07 or less, 0.08 or less, 0.09 or less, 0.1 or less, 0.11 or less, 0.12 or less, 0.13 or less, 0.14 or less, 0.15 or less, 0.16 or less, 0.17 or less, 0.18 or less, 0.19 or less, 0.2 or less, 0.21 or less, 0.22 or less, 0.23 or less, 0.24 or less, 0.25 or less, 0.26 or less, 0.27 or less, 0.28 or less, 0.29 or less, 0.3 or less, 0.31 or less, 0.32 or less, 0.33 or less, 0.34 or less, 0.35 or less, 0.36 or less, 0.37 or less, 0.38 or less, 0.39 or less, or less than 0.4. When b satisfies the above range, stability during a process of charge/discharge may be improved and rate characteristics are enhanced.

c is a mole fraction of manganese (Mn) among all metals excluding lithium in the lithium composite transition metal oxide, and may be greater than 0, 0.01 or greater, 0.02 or greater, 0.03 or greater, 0.04 or greater, 0.05 or greater, 0.06 or greater, 0.07 or greater, 0.08 or greater, 0.09 or greater, 0.1 or greater, 0.11 or greater, 0.12 or greater, 0.13 or greater, 0.14 or greater, 0.15 or greater, 0.16 or greater, 0.17 or greater, 0.18 or greater, 0.19 or greater, 0.2 or greater, 0.21 or greater, 0.22 or greater, 0.23 or greater, 0.24 or greater, 0.25 or greater, 0.26 or greater, 0.27 or greater, 0.28 or greater, 0.29 or greater, 0.3 or greater, or 0.31 or greater, and may be 0.32 or less, 0.33 or less, 0.34 or less, 0.35 or less, 0.36 or less, 0.37 or less, 0.38 or less, 0.39 or less, or less than 0.4. When the above range is satisfied, high capacity characteristics may be achieved. In addition, high temperature stability may be increased and side reactions with an electrolyte may be relatively reduced.

d is a mole fraction of $M^1$ among all metals excluding lithium in the lithium composite transition metal oxide, and may be 0 or greater, 0.001 or greater, 0.002 or greater, 0.003 or greater, or 0.004 or greater, and may be 0.005 or less, 0.006 or less, 0.007 or less, 0.008 or less, 0.009 or less, 0.01 or less, 0.02 or less, 0.03 or less, 0.04 or less, 0.05 or less, 0.06 or less, 0.07 or less, 0.08 or less, 0.09 or less, or 0.1 or less. When d satisfies the above range, the positive electrode active material may exhibit enhanced crystal structure stability and improved particle shape.

In addition, as for a and c, a-c may be 0.25 or greater, greater than 0.25, 0.26 or greater, 0.27 or greater, 0.28 or greater, 0.29 or greater, 0.3 or greater, or 0.31 or greater, and may be less than 0.34, 0.34 or less, 0.35 or less, 0.36 or less, 0.37 or less, 0.38 or less, 0.39 or less, 0.4 or less, 0.41 or less, 0.42 or less, 0.43 or less, 0.44 or less, or 0.45 or less. When a-c satisfies the above range, the average particle size ($D'_{50}$) of primary particles of the positive electrode active material may be appropriately adjusted to control electrode density and side reactions with an electrolyte, and capacity characteristics and lifespan characteristics may be improved. When a-c is less than 0.25, in a case in which the average particle size ($D'_{50}$) of primary particles of the positive electrode active material decreases, side reactions with an electrolyte increases, causing poor lifespan characteristics, and when a-c is greater than 0.45, electrode density decreases, causing poor capacity characteristics. In particular, when a-c is greater than 0.25 and less than 0.34, lifespan characteristics and resistance characteristics may be improved without compromising the charge/discharge capacity of a secondary battery.

A coating layer containing a coating element (M) formed on the lithium composite transition metal oxide is included and the coating element (M) is at least one selected from Al, W, Cu, Zr, Ni, Co, Sr, Mn, Y, Ti, Mg, Mo, B, Sn, Fe, Zn, and Si. When the coating layer includes the coating element (M), electrical conductivity may be improved and byproducts formed by a side reaction with an electrolyte may be controlled, thereby improving capacity characteristics, resistance characteristics, and lifespan characteristics. Specifically, the coating element (M) may be at least one selected from Al and W. In this case, there is an effect of suppressing the generation of byproducts in the form of hydrogen fluoride and exhibiting high-capacity characteristics at high rates. Meanwhile, when the coating layer including the coating element (M) formed on the lithium composite transition metal oxide is not included, electrical conductivity is inferior, and capacity characteristics, resistance characteristics, and lifespan characteristics are degraded due to byproducts formed by side reactions with an electrolyte.

The positive electrode active material according to the present invention has a single particle formation degree ($\chi$) of greater than 0.5 according to Equation 1 described herein. Specifically, the single particle formation degree ($\chi$) may be greater than 0.5, 0.51 or greater, 0.52 or greater, 0.53 or greater, 0.54 or greater, 0.55 or greater, 0.56 or greater, 0.57 or greater, 0.58 or greater, 0.59 or greater, 0.6 or greater, 0.61 or greater, or 0.62 or greater, and may be 0.87 or less, 0.88 or less, 0.89 or less, 0.90 or less, 0.91 or less, 0.92 or less, 0.93 or less, 0.94 or less, 0.95 or less, 0.96 or less, 0.97 or less, 0.98 or less, 0.99 or less, or 1 or less. When the single particle formation degree ($\chi$) is within the above range, it is seen that the lithium composite transition metal oxide of the present invention is in the form of a single particle with suppressed agglomeration between primary particles. In particular, when the single particle formation degree ($\chi$) is in a range of 0.6 to 0.9, the lithium composite transition metal oxide exhibits enhanced structural stability, leading to suppressed particle breakage during rolling for electrode manufacturing or cell operation, reduced grain boundary area in contact with an electrolyte, and reduced gas generation caused by side reactions with an electrolyte, and thus, secondary batteries may have improved lifespan characteristics and resistance characteristics. Meanwhile, when the degree of single particle formation is 0.5 or less, when rolling for electrode manufacturing or operating a cell, particle breakage occurs due to grain boundaries, a grain boundary area in contact with an electrolyte increases significantly, and gas generation caused by side reactions with the electrolyte increases, leading to degradation in lifespan characteristics.

According to an embodiment of the present invention, the coating layer may contain the coating element (M) in an amount of 3000 ppm to 5500 ppm with respect to a total weight of the lithium composite transition metal oxide. The coating element (M) may be provided in an amount of 3000 ppm or greater or 3100 ppm or greater, and in an amount of 3200 ppm or less, 3300 ppm or less, 3400 ppm or less, 3500 ppm or less, 3600 ppm or less, 3700 ppm or less, 3800 ppm or less, 3900 ppm or less, 4000 ppm or less, 4100 ppm or less, 4200 ppm or less, 4300 ppm or less, 4400 ppm or less, 4500 ppm or less, 4600 ppm or less, 4700 ppm or less, 4800 ppm or less, 4900 ppm or less, 5000 ppm or less, 5100 ppm or less, 5200 ppm or less, 5300 ppm or less, 5400 ppm or less, or 5500 ppm or less, with respect to a total weight of the lithium composite transition metal oxide. When the content of the coating element (M) is within the above range, electrical conductivity may be improved and byproducts formed by a side reaction with an electrolyte may be controlled, thereby improving capacity characteristics, resistance characteristics, and lifespan characteristics of the positive electrode active material.

According to an embodiment of the present invention, the coating layer may include a Li-M-O compound, and M may be at least one selected from Al, W, Cu, Zr, Ni, Co, Sr, Mn, Y, Ti, Mg, Mo, B, Sn, Fe, Zn, and Si. Specifically, when the coating layer is a Li-Al-O compound, a Li-W-O compound, or a combination thereof, electrical conductivity may be improved and byproducts formed by a side reaction with an electrolyte may be controlled, thereby improving capacity characteristics, resistance characteristics, and lifespan characteristics of the positive electrode active material.

According to an embodiment of the present invention, the primary particles may have an average particle size ($D'_{50}$) of 2 $\mu$m to 5 $\mu$m. Specifically, the primary particles may have an average particle size ($D'_{50}$) of 2 $\mu$m or greater, 2.1 $\mu$m or greater, 2.2 $\mu$m or greater, 2.3 $\mu$m or greater, 2.4 $\mu$m or greater, 2.41 $\mu$m or greater, 2.42 $\mu$m or greater, 2.43 $\mu$m or greater, 2.44 $\mu$m or greater, 2.45 $\mu$m or greater, 2.46 $\mu$m or greater, 2.47 $\mu$m or greater, 2.48 $\mu$m or greater, or 2.49 $\mu$m or greater, and an average particle size ($D'_{50}$) of 3.4 $\mu$m or less, 3.5 $\mu$m or less, 3.6 $\mu$m or less, 3.7 $\mu$m or less, 3.8 $\mu$m or less, 3.9 $\mu$m or less, 4 $\mu$m or less, 4.1 $\mu$m or less, 4.2 $\mu$m or less, 4.3 $\mu$m or less, 4.4 $\mu$m or less, 4.5 $\mu$m or less, 4.6 $\mu$m or less, 4.7 $\mu$m or less, 4.8 $\mu$m or less, 4.9 $\mu$m or less, or 5 $\mu$m or less. When the average particle size ($D'_{50}$) of primary particles is within the above range, side reactions between a positive electrode active material and an electrolyte is reduced, and thus lifespan characteristics may be improved and resistance characteristics may be improved due to a reduced lithium diffusion path inside the particles.

According to an embodiment of the present invention, the positive electrode active material may have an average particle size ($D_{50}$) of 3 $\mu$m to 5 $\mu$m. Specifically, the positive electrode active material may have an average particle size ($D_{50}$) of 3 $\mu$m or greater, 3.1 $\mu$m or greater, 3.2 $\mu$m or greater, 3.3 $\mu$m or greater, 3.4 $\mu$m or greater, 3.5 $\mu$m or greater, 3.6 $\mu$m or greater, 3.7 $\mu$m or greater, 3.8 $\mu$m or greater, or 3.9 $\mu$m or greater, and an average particle size ($D_{50}$) of 4.02 $\mu$m or less, 4.03 $\mu$m or less, 4.04 $\mu$m or less, 4.05 $\mu$m or less, 4.06 $\mu$m or less, 4.07 $\mu$m or less, 4.08 $\mu$m or less, 4.09 $\mu$m or less, 4.1 $\mu$m or less, 4.2 $\mu$m or less, 4.3 $\mu$m or less, 4.4 $\mu$m or less, 4.5 $\mu$m or less, 4.6 $\mu$m or less, 4.7 $\mu$m or less, 4.8 $\mu$m or less, 4.9 $\mu$m or less, or 5 $\mu$m or less. When the average particle size ($D_{50}$) of the positive electrode active material is within the above range, excellent electrode density may be achieved and structural stability may be improved.

## Method for preparing positive electrode active material

Next, a method for preparing a positive electrode active material according to the present invention will be described. The method for preparing a positive electrode active material of the present invention is a method for preparing the positive electrode active material according to the present invention.

The method for preparing the positive electrode active material of the present invention includes (A) mixing and firing a composite transition metal hydroxide and a lithium (Li)-containing raw material to prepare a lithium composite transition metal oxide, and (B) mixing the lithium composite transition metal oxide and a coating element (M)-containing raw material and then heat treating the mixture to form a coating layer, wherein the firing is performed at a temperature of 800 °C to 1100 °C, and the coating element (M) is at least one selected from Al, W, Cu, Zr, Ni, Co, Sr, Mn, Y, Ti, Mg, Mo, B, Sn, Fe, Zn, and Si.

The positive electrode active material according to the present invention described above may be prepared by appropriately regulating the type of raw material, the mixing ratio of raw materials, heat treatment temperature, firing and heat treatment duration, and the like.

Hereinafter, the present invention will be described in detail for each step.

## Step A

The method for preparing the positive electrode active material according to the present invention includes step A of mixing and firing a composite transition metal hydroxide and a lithium (Li)-containing raw material to prepare a lithium composite transition metal oxide.

The composite transition metal hydroxide may be prepared by adding a composite transition metal aqueous solution, an ammonium cation complex forming agent, and a basic compound into a reactor and subjecting the mixture to a co-precipitation reaction.

The composite transition metal-containing solution may contain nickel (Ni), cobalt (Co), and manganese (Mn).

The composite transition metal aqueous solution may be prepared by dissolving a transition metal-containing raw material in a solvent such as water and may be prepared, for example, by dissolving a nickel (Ni)-containing raw material, a cobalt (Co)-containing raw material, and a manganese (Mn)-containing raw material in water. That is, the composite transition metal-containing solution may include a nickel (Ni)-containing raw material, a cobalt (Co)-containing raw material, and a manganese (Mn)-containing raw material. In addition, when needed, the composite transition metal-containing solution may further include a metal-containing raw material containing a transition metal excluding nickel (Ni), cobalt (Co), and manganese (Mn) (e.g., at least one selected from Zr, Y, W, Cu, Sr, Mn, Ti, Mg, Mo, B, Sn, Fe, Zn, Si, and Al).

The nickel (Ni)-containing raw material may be at least one selected from the group consisting of $NiSO_4$, NiO, $Ni(OH)_2$, $NiO \cdot OH$, $NiCO_3 \cdot 2Ni(OH)_2 \cdot 4H_2O$, $NiC_2O_4 \cdot 2H_2O$, $Ni(NO_3)_2 \cdot 6H_2O$, fatty acid nickel, and nickel halides, and any one thereof or a mixture of two or more thereof may be used.

The cobalt (Co)-containing raw material may be at least one selected from the group consisting of $Co(OH)_2$, $Co_3O_4$, $CoO \cdot OH$, $Co(OCOCH_3)_2 \cdot 4H_2O$, $Co(NO_3)_2 \cdot 6H_2O$ or $Co(SO_4)_2 \cdot 7H_2O$, fatty acid cobalt, and cobalt halides, and any one thereof or a mixture of two or more thereof may be used.

The manganese (Mn)-containing raw material may be at least one selected from the group consisting of $MnCO_3$, $Mn_2O_3$, $MnO_2$, $Mn_3O_4$, $Mn(NO_3)_2$, manganese acetate, manganese dicarboxylate, manganese citrate, manganese salts of fatty acid manganese, oxyhydroxides, and halides of manganese chloride, and any one thereof or a mixture of two or more thereof may be used.

The metal-containing raw material may be at least one selected from the group consisting of carbonate, nitrate, hydroxide, oxide, oxyhydroxide, and halide, containing at least one transition metal other than nickel (Ni), cobalt (Co), and manganese (Mn), and any one thereof or a mixture of two or more thereof may be used.

The nickel (Ni)-containing raw materials, the cobalt (Co)-containing raw materials, and the manganese (Mn)-containing raw materials may be used in appropriate amounts, considering the content of each metal element in the composite transition metal hydroxide being prepared.

Meanwhile, the ammonium cation complex forming agent may include at least one compound selected from the group consisting of $NH_4OH$, $(NH_4)_2SO_4$, $NH_4NO_3$, $NH_4Cl$, $CH_3COONH_4$, and $NH_4CO_3$, and may be put into a reactor in the form of a solution in which the compound is dissolved in a solvent. In this case, as the solvent, water, or a mixture of an organic solvent (specifically, alcohol or the like) that may be uniformly mixed with water and water may be used.

The basic compound may be at least one compound selected from the group consisting of NaOH, KOH, and $Ca(OH)_2$, and may be put into a reactor in the form of a solution in which the compound is dissolved in a solvent. In this case, as the solvent, water, or a mixture of an organic solvent (specifically, alcohol or the like) that may be uniformly mixed with water and water may be used.

As described above, when the composite transition metal-containing solution, the ammonium cation complex forming agent, and the basic compound are put into a reactor, precursor particles in the form of composite transition metal hydroxide are generated due to coprecipitation reactions between transition metals in the composite transition metal-containing solution and hydroxide ions of the basic compound.

The co-precipitation reaction may be performed for 1 hour to 50 hours. Specifically, the co-precipitation reaction may be performed for 1 hour or more, 5 hours or more, 10 hours or more, 11 hours or more, 12 hours or more, 13 hours or more, 14 hours or more, 15 hours or more, 16 hours or more, 17 hours or more, 18 hours or more, 19 hours or more, or 20 hours or more, and for 30 hours or less, 31 hours or less, 32 hours or less, 33 hours or less, 34 hours or less, 35 hours or less, 36 hours or less, 37 hours or less, 38 hours or less, 39 hours or less, 40 hours or less, 45 hours or less, or 50 hours or less. When the coprecipitation reaction is performed for a duration within the above range, the crystallinity of the precursor particles may be controlled to a sufficient degree.

In this case, the basic compound may be added in an amount such that the pH of the reaction solution is within a desired range. The co-precipitation reaction may be performed at a pH of 10 to 13. Specifically, the co-precipitation reaction may be performed at a pH of 10 or higher, a pH of 10.5 or higher, a pH of 11 or higher, or a pH 11.5 or higher, and a pH of 12 or less, a pH of 12.5 or less, a pH of 12.7 or less, or a pH of 13 or less.

When the precursor particles are formed through the method described above, the particles are separated from the reaction solution to obtain a composite transition metal hydroxide. Specifically, the reaction solution may be filtered to separate the precursor particles from the reaction solution, and then the separated precursor particles may be washed and dried to obtain a composite transition metal hydroxide. In this case, as needed, a process such as grinding and/or classification may be performed.

The composite transition metal hydroxide may have a composition represented by $Ni_pCo_qMn_rM^2_s(OH)_2$ (where $M^2$ is at least one selected from Zr, Y, W, Cu, Sr, Mn, Ti, Mg, Mo, B, Sn, Fe, Zn, Si, and Al, and p, q, r, and s satisfy $0.6 \leq p < 1$, $0 < q < 0.4$, $0 < r < 0.4$, $0 \leq s \leq 0.1$, and $p+q+r+s=1$).

The lithium (Li)-containing raw material may be at least one selected from the group consisting of $LiOH$, $Li_2CO_3$, $LiNO_3$, $LiNO_2$, $LiOH \cdot H_2O$, $LiH$, $LiF$, $LiCl$, $LiBr$, $LiI$, $CH_3COOLi$, $Li_2O$, Li acetate, Li dicarboxylic acid, Li citrate, Li fatty acid, alkyl lithium, and lithium halides, and any one thereof or a mixture of two or more thereof may be used. Specifically, $Li_2CO_3$ may be used considering the similarity between the melting point of the lithium (Li)-containing raw material and firing temperature, and economic efficiency.

The mixing may be performed by dry mixing or wet mixing. When mixing each component through dry mixing, the firing process may be performed without a separate drying process. In the case of mixing each component through wet mixing, the mixing is performed by adding a solvent, specifically water, or a mixture of water and an organic solvent (specifically alcohol or the like) that may be uniformly mixed with water, or preparing a solution containing each raw material, specifically an aqueous solution, and then mixing the solution, spray drying, and then firing the mixed components. Each raw material and composite transition metal hydroxide may be used in an appropriate amount, considering the content of each metal element in the lithium composite transition metal oxide to be finally prepared.

According to an embodiment of the present invention, in step A, the composite transition metal hydroxide and the lithium (Li)-containing raw material may be mixed in an amount to achieve a composition represented by Formula 1 above.

The firing is performed at a temperature of 800 °C to 1100 °C. Specifically, the firing is performed at a temperature of 800 °C or greater, 810 °C or greater, 820 °C or greater, 830 °C or greater, 840 °C or greater, 850 °C or greater, 860 °C or greater, 870 °C or greater, 880 °C or greater, 890 °C or greater, 900 °C or greater, 910 °C or greater, 920 °C or greater, 930 °C or greater, or 940 °C or greater, and at a temperature of 950 °C or less, 960 °C or less, 970 °C or less, 980 °C or less, 990 °C or less, 1000 °C or less, 1010 °C or less, 1020 °C or less, 1030 °C or less, 1040 °C or less, 1050 °C or less, 1060 °C or less, 1070 °C or less, 1080 °C or less, 1090 °C or less, or 1100 °C or less. When the firing temperature is within the above range, primary particles may grow to an appropriate degree to improve capacity characteristics and lifespan characteristics. When performed at a temperature below 800 °C, the particle growth is not sufficient, and thus a positive electrode active material in the form of secondary particle in which more than 10 primary particles are aggregated is formed, leading to degradation in lifespan characteristics. When performed at a temperature above 1100 °C, primary particles overgrow and the lithium movement decreases, and thus resistance increases and capacity characteristics decrease.

The firing may be performed in an air atmosphere, an oxygen atmosphere, or an inert atmosphere. Specifically, the firing may be performed in an air atmosphere given the ease of maintaining the firing atmosphere and economic benefits.

The firing may be performed for 10 hours to 18 hours. Specifically, the firing may be performed for 10 hours or more, 11 hours or more, 12 hours or more, 13 hours or more, or 14 hours or more, and for 15 hours or less, 16 hours or less, 17 hours or less, or 18 hours or less. When the firing duration is within the above range, the crystallinity of the lithium composite transition metal oxide particles is sufficiently controlled, benefiting lithium ion transport.

**Step B**

The method for preparing a positive electrode active material according to the present invention includes, after step (A), mixing the lithium composite transition metal oxide and a coating element (M)-containing raw material and then heat treating the mixture to form a coating layer.

The coating element (M) is at least one selected from Al, W, Cu, Zr, Ni, Co, Sr, Mn, Y, Ti, Mg, Mo, B, Sn, Fe, Zn, and Si. By forming a coating layer containing the coating element (M) on the lithium composite transition metal oxide, electrical conductivity may be improved and byproducts formed by a side reaction with an electrolyte may be controlled, thereby improving capacity characteristics, resistance characteristics, and lifespan characteristics of the positive electrode active material. Meanwhile, when the coating layer containing the coating element (M) on the lithium composite transition metal oxide is not formed, electrical conductivity is inferior, and capacity characteristics, resistance characteristics, and lifespan characteristics are degraded due to byproducts formed by side reactions with an electrolyte.

According to an embodiment of the present invention, as the coating element (M)-containing raw material, at least one selected from oxide, carbonate, nitrate, hydroxide, oxyhydroxide, and halide, containing the coating element (M) may be used. To exhibit the effect of suppressing the generation of byproducts in the form of hydrogen fluoride and exhibiting high capacity characteristics at high rates, specifically, an oxide including a coating element (M) may be used, and the coating element (M) may be Al or W.

According to an embodiment of the present invention, the coating element (M)-containing raw material may be mixed to achieve the coating element (M) in an amount of 3000 ppm to 5500 ppm with respect to a total weight of the lithium composite transition metal oxide. Specifically, the mixing may be performed to achieve the coating element (M) in an amount of 3000 ppm or greater, 3100 ppm or greater, 3200 ppm or greater, 3300 ppm or greater, 3400 ppm or greater, 3500 ppm or greater, 3600 ppm or greater, 3700 ppm or greater, 3800 ppm or greater, 3900 ppm or greater, 4000 ppm or greater, 4100 ppm or greater, 4200 ppm or greater, 4300 ppm or greater, 4400 ppm or greater, or 4500 ppm or greater, and in an amount of 4600 ppm or less, 4700 ppm or less, 4800 ppm or less, 4900 ppm or less, 5000 ppm or less, 5100 ppm or less, 5200 ppm or less, 5300 ppm or less, 5400 ppm or less, or 5500 ppm or less, with respect to a total weight of the lithium composite transition metal oxide. When the mixing amount of the coating element (M)-containing raw material is within the above range, electrical conductivity may be improved and byproducts formed by a side reaction with an electrolyte may be controlled, thereby improving capacity characteristics and lifespan characteristics of the positive electrode active material.

The heat treatment may be performed in an air atmosphere, an oxygen atmosphere, or an inert atmosphere. Specifically, the heat treatment may be performed in an air atmosphere given the ease of maintaining the heat treatment atmosphere and economic benefits.

According to an embodiment of the present invention, the firing may be performed at a temperature of 400 °C to 600 °C. Specifically, the heat treatment may be performed at a temperature of 400 °C or greater, 410 °C or greater, 420 °C or greater, 430 °C or greater, 440 °C or greater, 450 °C or greater, 460 °C or greater, 470 °C or greater, 480 °C or greater, 490 °C or greater, or 500 °C or greater, and at a temperature of 510 °C or less, 520 °C or less, 530 °C or less, 540 °C or less, 550 °C or less, 560 °C or less, 570 °C or less, 580 °C or less, 590 °C or less, or 600 °C or less. When the heat treatment temperature is within the above range, the heat energy required for coating may be sufficiently supplied. When the lithium composite transition metal oxide and the coating M raw material are mixed and then heat treated within the above temperature range, a coating layer containing coating element (M) may be formed on the lithium composite transition metal oxide. The coating layer containing the coating element (M) may partially cover (discontinuously) at least a portion of the lithium composite transition metal oxide, i.e., a region of the lithium composite transition metal oxide, or may cover (continuously) an entire region. The coating layer may be of a film type, an island type, or a combination thereof.

The heat treatment may be performed for 3 hours to 9 hours. Specifically, the heat treatment may be performed for 3 hours or more, 4 hours or more, or 5 hours or more, and for 6 hours or less, 7 hours or less, 8 hours or less, or 9 hours or less. When the heat treatment duration is within the above range, heat energy may be supplied to a sufficient degree to form a coating layer.

**Positive electrode**

Next, a positive electrode according to the present invention will be described.

The positive electrode according to the present invention includes a positive electrode active material layer including the positive electrode active material according to the present invention. Specifically, the positive electrode includes a positive electrode current collector, and a positive electrode active material layer provided on the positive electrode current collector and including the positive electrode active material. Since the positive electrode active material has been described above, the detailed description thereof will be skipped, and hereinafter, the other components will only be described.

The positive electrode current collector is not particularly limited as long as it has conductivity without causing chemical changes in batteries. For example, stainless steel, aluminum, nickel, titanium, fired carbon, or aluminum or stainless steel that is surface-treated with one of carbon, nickel, titanium, silver, and the like may be used. In addition, the positive electrode current collector may typically have a thickness of 3 $\mu$m to 500 $\mu$m, and fine irregularities may be formed on a surface of the current collector to improve the adhesion of a positive electrode active material. For example, the positive electrode current collector may be used in various forms such as a film, a sheet, a foil, a net, a porous body, a foam body, and a non-woven fabric body.

The positive electrode active material layer may include a conductive material and a binder, together with a positive electrode active material. In this case, the positive electrode active material may be included in an amount of 80 wt% to 99 wt%, for example, 85 wt% to 98.5 wt% with respect to a total weight of the positive electrode active material layer, and excellent capacity properties may be obtained within this range.

The conductive material is used to impart conductivity to an electrode, and any conductive material may be used without particular limitation as long as it has electron conductivity without causing chemical changes in batteries to be constituted. Specific examples thereof may include graphite such as natural graphite or artificial graphite; a carbon-based material such as carbon black, acetylene black, Ketjen black, channel black, furnace black, lamp black, thermal black, and carbon fiber; metal powder or metal fiber such as copper, nickel, aluminum, and silver; a conductive whisker such as a zinc oxide whisker and a potassium titanate whisker; a conductive metal oxide such as a titanium oxide; or a conductive polymer such as a polyphenylene derivative, and any one thereof or a mixture of two or more thereof may be used. The conductive material may be included in an amount of 0.1 wt% to 15 wt% with respect to the total weight of the positive electrode active material layer.

The binder serves to improve the bonding between positive electrode active material particles and the adhesion between the positive electrode active material and the current collector. Specific examples thereof may include polyvinylidene fluoride (PVDF), a polyvinylidene fluoride-hexafluoropropylene copolymer (PVDF-co-HFP), polyvinyl alcohol, polyacrylonitrile, carboxymethyl cellulose (CMC), starch, hydroxypropyl cellulose, regenerated cellulose, polyvinylpyrrolidone, tetrafluoroethylene, polyethylene, polypropylene, an ethylene-propylene-diene polymer (EPDM), a sulfonated EPDM, styrene-butadiene rubber (SBR), fluorine rubber, or various copolymers thereof, and any one thereof or a mixture of two or more thereof may be used. The binder may be included in an amount of 0.1 wt% to 15 wt% with respect to the total weight of the positive electrode active material layer.

The positive electrode may be prepared according to a typical method of preparing a positive electrode, except that the positive electrode active material described above is used. Specifically, a composition for forming a positive electrode active material layer, which is prepared by dissolving or dispersing the positive electrode active material and optionally, a binder and a conductive material in a solvent, may be applied onto the positive electrode current collector, and then dried and rolled to prepare the positive electrode. In this case, types and amounts of the positive electrode active material, the binder, and the conductive material are as described above. In addition, in another method, the positive electrode may be prepared by casting a composition for forming the positive electrode material layer on a separate support and then laminating a film separated from the support on the positive electrode current collector.

The solvent may be a solvent commonly used in the art, and may be dimethyl sulfoxide (DMSO), isopropyl alcohol, N-methylpyrrolidone (NMP), acetone, water, or the like, and any one thereof or a mixture of two or more thereof may be used. An amount of the solvent used may be sufficient if the solvent may dissolve or disperse the positive electrode active material, the conductive material, and the binder in consideration of an applying thickness of the slurry and preparation yield, and thereafter, have a viscosity which may exhibit excellent thickness uniformity upon application for the preparation of the positive electrode.

**Lithium secondary battery**

Next, a lithium secondary battery according to the present invention will be described.

The present invention may manufacture an electrochemical device including the positive electrode. The electrochemical device may be specifically a battery, a capacitor, or the like, and more specifically, may be a lithium secondary battery.

Specifically, the lithium secondary battery includes a positive electrode, a negative electrode positioned to face the positive electrode, a separator interposed between the positive electrode and the negative electrode, and an electrolyte. The positive electrode is the same as described above, and thus, a detailed description thereof will be skipped, and hereinafter, the other components will only be described.

In addition, the lithium secondary battery may further optionally include a battery container accommodating an electrode assembly of the positive electrode, the negative electrode, and the separator, and a sealing member sealing the battery container.

In the lithium secondary battery, the negative electrode includes a negative electrode current collector and a negative electrode active material layer positioned on the negative electrode current collector.

The negative electrode current collector is not particularly limited as long as it has a high conductivity without causing chemical changes in batteries. For example, copper, stainless steel, aluminum, nickel, titanium, fired carbon, copper or stainless steel that is surface-treated with one of carbon, nickel, titanium, silver, and the like, an aluminum-cadmium alloy, and the like may be used. In addition, the negative electrode current collector may typically have a thickness of 3 $\mu$m to 500 $\mu$m, and as in the case of the positive electrode current collector, fine irregularities may be formed on the surface of the current collector to improve the adhesion of a negative electrode active material. For example, the negative electrode current collector may be used in various forms such as a film, a sheet, a foil, a net, a porous body, a foam body, and a non-woven fabric body.

The negative electrode active material layer optionally includes a binder and a conductive material in addition to the negative electrode active material.

A compound capable of reversibly intercalating and deintercalating lithium may be used as the negative electrode active material. Specific examples thereof may include a carbonaceous material such as artificial graphite, natural graphite, graphitized carbon fiber, and amorphous carbon; a metallic compound alloyable with lithium such as Si, Al, Sn, Pb, Zn, Bi, In, Mg, Ga, Cd, an Si alloy, an Sn alloy, or an Al alloy; a metal oxide which may be doped and undoped with lithium such as $SiO_\beta$ ($0<\beta<2$), $SnO_2$, a vanadium oxide, and a lithium vanadium oxide; or a composite including the metallic compound and the carbonaceous material such as an Si-C composite or an Sn-C composite, and any one thereof or a mixture of two or more thereof may be used. In addition, a metallic lithium thin film may be used as the negative electrode active material. In addition, as the carbon material, both low crystalline carbon and high crystalline carbon may be used. Typical examples of the low crystalline carbon may be soft carbon and hard carbon, and typical examples of the high crystalline carbon may be irregular, planar, flaky, spherical, or fibrous natural graphite or artificial graphite, Kish graphite, pyrolytic carbon, mesophase pitch-based carbon fibers, meso-carbon microbeads, mesophase pitches, and high-temperature fired carbon such as petroleum or coal tar pitch derived cokes.

The negative electrode active material may be included in an amount of 80 wt% to 99 wt% with respect to the total weight of a negative electrode active material layer.

The binder is a component for assisting in bonding between a conductive material, an active material, and a current collector, and is typically added in an amount of 0.1 wt% to 10 wt% with respect to the total weight of a negative electrode active material layer. Examples of the binder may include polyvinylidene fluoride (PVDF), polyvinyl alcohol, carboxymethyl cellulose (CMC), starch, hydroxypropyl cellulose, regenerated cellulose, polyvinylpyrrolidone, tetrafluoroethylene, polyethylene, polypropylene, an ethylene-propylene-diene monomer (EPDM), a sulfonated EPDM, styrene-butadiene rubber, nitrile-butadiene rubber, fluorine rubber, various copolymers thereof, and the like.

The conductive material is a component for further improving the conductivity of a negative electrode active material, and may be added in an amount of 10 wt% or less, specifically 5 wt% or less, with respect to the total weight of a negative electrode active material layer. The conductive material is not particularly limited as long as it has conductivity without causing chemical changes in batteries, and, for example, a conductive material, such as: graphite such as natural graphite or artificial graphite; carbon black such as acetylene black, Ketjen black, channel black, furnace black, lamp black, and thermal black; conductive fibers such as carbon fibers or metal fibers; fluorocarbon; metal powder such as aluminum powder and nickel powder; conductive whiskers such as zinc oxide whiskers and potassium titanate whiskers; conductive metal oxide such as titanium oxide; or polyphenylene derivatives, may be used.

The negative electrode active material layer may be prepared by applying a composition for forming a negative electrode active material layer, which is prepared by dissolving or dispersing a negative electrode active material and optionally a binder and a conductive material in a solvent, on a negative electrode collector, followed by drying, or may be prepared by casting a composition for forming a negative electrode active material layer on a separate support and then laminating a film separated from the support on the negative electrode collector.

Meanwhile, in the lithium secondary battery, a separator is to separate the negative electrode and the positive electrode and to provide a movement path for lithium ions. Any separator may be used without particular limitation as long as it is typically used as a separator in a lithium secondary battery. Particularly, a separator having high moisture-retention ability for an electrolyte as well as low resistance to the movement of electrolyte ions is preferable. Specifically, a porous polymer film, for example, a porous polymer film prepared using a polyolefin-based polymer such as an ethylene homopolymer, a propylene homopolymer, an ethylene/butene copolymer, an ethylene/hexene copolymer, and an ethylene/methacrylate copolymer, or a laminated structure having two or more layers thereof may be used. In addition, a typical porous nonwoven fabric, for example, a nonwoven fabric formed of glass fiber having a high melting point or polyethylene terephthalate fiber may be used. Furthermore, a coated separator including a ceramic component or a polymer material may be used to secure heat resistance or mechanical strength, and a separator having a single-layer structure or a multi-layer structure may be optionally used.

In addition, the electrolyte used in the present invention may be an organic liquid electrolyte, an inorganic liquid electrolyte, a solid polymer electrolyte, a gel-type polymer electrolyte, a solid inorganic electrolyte, a molten-type inorganic electrolyte, and the like, all of which may be used in the manufacture of a lithium secondary battery, but is not limited thereto.

Specifically, the electrolyte may include an organic solvent and a lithium salt.

Any organic solvent may be used without particular limitation as long as it may serve as a medium through which ions involved in an electrochemical reaction of a battery may move. Specifically, as the organic solvent, an ester-based solvent such as methyl acetate, ethyl acetate, $\gamma$-butyrolactone, and $\varepsilon$-caprolactone; an ether-based solvent such as dibutyl ether or tetrahydrofuran; a ketone-based solvent such as cyclohexanone; an aromatic hydrocarbon-based solvent such as benzene and fluorobenzene; a carbonate-based solvent such as dimethyl carbonate (DMC), diethyl carbonate (DEC), ethylmethyl carbonate (EMC), ethylene carbonate (EC), and propylene carbonate (PC); an alcohol-based solvent such as ethyl alcohol and isopropyl alcohol; nitriles such as R-CN (where R is a linear, branched, or cyclic C2 to C20 hydrocarbon group and may include a double-bond aromatic ring or ether bond); amides such as dimethylformamide; dioxolanes such as 1,3-dioxolane; or sulfolanes may be used. Among these solvents, a carbonate-based solvent is preferable, and a mixture of a cyclic carbonate (e.g., ethylene carbonate or propylene carbonate) having a high ionic conductivity and a high dielectric constant and a linear carbonate-based compound having a low viscosity (e.g., ethylmethyl carbonate, dimethyl carbonate, or diethyl carbonate), the mixture which may increase charging/discharging performance of a battery, is more preferable. In this case, the electrolyte may exhibit excellent performance when the cyclic carbonate and the chain carbonate are mixed in a volume ratio of about 1:1 to about 1:9.

Any compound may be used as the lithium salt without particular limitation as long as it may provide lithium ions used in a lithium secondary battery. Specifically, as the lithium salt, $LiPF_6$, $LiClO_4$, $LiAsF_6$, $LiBF_4$, $LiSbF_6$, $LiAlO_4$, $LiAlCl_4$, $LiCF_3SO_3$, $LiC_4F_9SO_3$, $LiN(C_2F_5SO_3)_2$, $LiN(C_2F_5SO_2)_2$, $LiN(CF_3SO_2)_2$, $LiCl$, $LiI$, $LiB(C_2O_4)_2$, or the like may be used. The lithium salt may be used in a concentration range of 0.1 M to 5.0 M, specifically 0.1 M to 3.0 M. When the concentration of the lithium salt is included within the above range, the electrolyte has suitable conductivity and viscosity and may thus exhibit excellent performance, and lithium ions may effectively move.

In the electrolyte, in order to improve the lifespan characteristics of a battery, suppress the decrease in battery capacity, and improve the discharge capacity of a battery, at least one additive, for example, a halo-alkylene carbonate-based compound such as difluoroethylene carbonate, pyridine, triethylphosphite, triethanolamine, cyclic ether, ethylenediamine, n-glyme, hexaphosphoric triamide, a nitrobenzene derivative, sulfur, a quinone imine dye, N-substituted oxazolidinone, N,N-substituted imidazolidine, ethylene glycol dialkyl ether, an ammonium salt, pyrrole, 2-methoxy ethanol, or aluminum trichloride may be further included. In this case, the additive may be included in an amount of 0.1 wt% to 10 wt%, specifically 0.1 wt% to 5 wt%, with respect to a total weight of the electrolyte.

The lithium secondary battery including the positive electrode active material according to the present invention as describe above exhibits superior lifespan characteristics and capacity characteristics, and thus, are useful for portable devices such as a mobile phone, a notebook computer, and a digital camera, and in the field of electric cars such as a hybrid electric vehicle (HEV).

Thus, according to another embodiment of the present invention, a battery module including the lithium secondary battery as a unit cell, and a battery pack including the same are provided.

The battery module or the battery pack may be used as a power source of at least any one medium and large sized device of a power tool; electric cars including an electric vehicle (EV), a hybrid electric vehicle, and a plug-in hybrid electric vehicle (PHEV); or a power storage system.

An outer shape of the lithium secondary battery of the present invention is not particularly limited, but a cylindrical type using a can, a prismatic type, a pouch type, or a coin type may be used.

The lithium secondary battery according to the present invention may be used in a battery cell which is used as a power source for a small-sized device, and may also be preferably used as a unit cell for a medium- and large-sized battery module including a plurality of battery cells.


## MODE FOR CARRYING OUT THE INVENTION

Hereinafter, examples of the present invention will be described in detail in such a manner that it may easily be performed by a person with ordinary skill in the art to which the present invention pertains. The present invention may, however, be embodied in many different forms, and is not limited to examples set forth herein.


## Examples and Comparative Examples


## Example 1

A composite transition metal hydroxide having a composition represented by $Ni_{0.62}Co_{0.06}Mn_{0.32}(OH)_2$ (product name: nickel cobalt manganese hydroxide, $D_{50}$: 3.5 $\mu$m, BET: 15 $m^2$/g, secondary particle) and $Li_2CO_3$ were added to achieve a molar ratio of (Ni+Co+Mn):Li of 1:1.05, and $Y_2O_3$ and $ZrO_2$ were added to achieve Y and Zr in an amount of 1500 ppm and 3000 ppm, respectively, with respect to a total weight of $Ni_{0.62}Co_{0.06}Mn_{0.32}(OH)_2$, mixed, and then fired at 940 °C for 14 hours in an air atmosphere to prepare a lithium composite transition metal oxide having a composition represented by $LiNi_{0.625}Co_{0.06}Mn_{0.311}Zr_{0.003}Y_{0.001}O_2$.

The lithium composite transition metal oxide, $Al_2O_3$, and $WO_3$ were mixed and heat treated at 500 °C for 5 to 7 hours in an air atmosphere to prepare a positive electrode active material in which a coating layer containing Al and W was formed on the lithium composite transition metal oxide. In this case, the $Al_2O_3$ was mixed to achieve Al in an amount of 1500 ppm with respect to a total weight of the $LiNi_{0.625}Co_{0.06}Mn_{0.311}Zr_{0.003}Y_{0.001}O_2$, and the $WO_3$ was mixed to achieve W in an amount of 3000 ppm with respect to a total weight of the $LiNi_{0.625}Co_{0.06}Mn_{0.311}Zr_{0.003}Y_{0.001}O_2$. The coating layer includes a Li-Al-O compound, a Li-W-O compound, and a Li-Al-W-O compound.

**Example 2**

A positive electrode active material was prepared in the same manner as in Example 1, except that a composite transition metal hydroxide having a composition represented by $Ni_{0.65}Co_{0.05}Mn_{0.30}(OH)_2$ (product name: nickel cobalt manganese hydroxide, $D_{50}$: 3.5 $\mu$m, BET: 15 $m^2$/g, secondary particle) was used instead of a composite transition metal hydroxide having a composition represented by $Ni_{0.62}Co_{0.06}Mn_{0.32}(OH)_2$.

**Comparative Example 1**

A positive electrode active material was prepared in the same manner as in Example 1, except that a composite transition metal hydroxide having a composition represented by $Ni_{0.60}Co_{0.05}Mn_{0.35}(OH)_2$ (product name: nickel cobalt manganese hydroxide, $D_{50}$: 3.5 $\mu$m, BET: 15 $m^2$/g, secondary particle) was used instead of a composite transition metal hydroxide having a composition represented by $Ni_{0.62}Co_{0.06}Mn_{0.32}(OH)_2$.

**Comparative Example 2**

The lithium composite transition metal oxide of Example 1 was used as a positive electrode active material of Comparative Example 2.

**Comparative Example 3**

A positive electrode active material was prepared in the same manner as in Example 1, except that a composite transition metal hydroxide having a composition represented by $Ni_{0.685}Co_{0.095}Mn_{0.220}(OH)_2$ (product name: nickel cobalt manganese hydroxide, $D_{50}$: 3.5 $\mu$m, BET: 15 $m^2$/g, secondary particle) was used instead of a composite transition metal hydroxide having a composition represented by $Ni_{0.62}Co_{0.06}Mn_{0.32}(OH)_2$.

**Experimental Examples**

**Experimental Example 1: Analysis of lithium composite transition metal oxide**

**- Composition of lithium composite transition metal oxide**

For the lithium composite transition metal oxides prepared in Example and Comparative Example above, the composition of the lithium composite transition metal oxides was confirmed by the following method, and is shown in Table 1 below.

1 ml of hydrochloric acid was added to 0.1 g of each of the lithium composite transition metal oxide particles prepared in Example and Comparative Example, and the mixture was heated to dissolve the lithium composite transition metal oxide. Thereafter, a small amount of hydrogen peroxide was added to promote a reaction, and the lithium composite transition metal oxide was completely dissolved to prepare a solution. Then, the solution was diluted to a total volume of 10 mL with deionized water to prepare an analysis sample. Using ICP-OES (Aligent5100, Aligent), the composition of the lithium composite transition metal oxide present in the above analysis sample was determined and the composition of the lithium composite transition metal oxide and the difference in mole fraction of nickel and manganese (a-c) are shown in Table 1 below.

[Table 1]

|  | Composition | a-c |
|---|---|---|
| Example 1 | $Li_{1.032}Ni_{0.624}Co_{0.06}Mn_{0.312}Zr_{0.003}Y_{0.001}O_2$ | 0.312 |
| Example 2 | $Li_{1.035}Ni_{0.643}Co_{0.051}Mn_{0.302}Zr_{0.003}Y_{0.001}O_2$ | 0.341 |
| Comparative Example 1 | $Li_{1.030}Ni_{0.598}Co_{0.05}Mn_{0.348}Zr_{0.003}Y_{0.001}O_2$ | 0.25 |
| Comparative Example 2 | $Li_{1.028}Ni_{0.624}Co_{0.06}Mn_{0.312}Zr_{0.003}Y_{0.001}O_2$ | 0.312 |

(continued)

|  | Composition | a-c |
|---|---|---|
| Comparative Example 3 | $Li_{1.027}Ni_{0.680}Co_{0.097}Mn_{0.219}Zr_{0.003}Y_{0.001}O_2$ | 0.463 |

As shown in Table 1, it is determined that the lithium composite transition metal oxides prepared in Examples 1 and 2 had a composition represented by Formula 1 described herein. In addition, it is determined that in the lithium composite transition metal oxides prepared in Examples 1 and 2 and Comparative Examples 1 and 2, a difference in mole fraction of nickel and manganese, that is, a difference between a, the mole fraction of nickel (Ni) among all metals excluding lithium in the lithium composite transition metal oxide in the composition represented by Formula 1 described herein and c, the mole fraction of manganese (Mn) among all metals excluding lithium in the lithium composite transition metal oxide (a-c) was 0.25 to 0.45. Meanwhile, it is determined that in the lithium composite transition metal oxide prepared in Comparative Example 3, a-c was greater than 0.45.

**Experimental Example 2: Analysis of positive electrode active material**

**- Content of coating element (M) included in coating layer**

For the positive electrode active materials prepared in Examples and Comparative Examples, the content of aluminum (Al) and tungsten (W) included in the coating layer was determined through the following method, and is shown in Table 2 below.

1 ml of hydrochloric acid was added to 0.1 g of each of the positive electrode active material particles prepared in Example and Comparative Example, and the mixture was heated to dissolve the positive electrode active material. Thereafter, a small amount of hydrogen peroxide was added to promote a reaction, and the positive electrode active material was completely dissolved to prepare a solution. Then, the solution was diluted to a total volume of 10 mL with deionized water to prepare an analysis sample. Using ICP-OES (Optima 7300DV, Perkin Elmer), the content (ppm) of aluminum (Al) and tungsten (W) included in the positive electrode active material coating layer present in the above analysis sample was determined, and the results are shown in Table 2 below.

[Table 2]

|  | Content (ppm) | |
|---|---|---|
|  | Aluminum (Al) | Tungsten (W) |
| Example 1 | 1,120 | 2,050 |
| Example 2 | 1,180 | 2,090 |
| Comparative Example 1 | 1,230 | 2,240 |
| Comparative Example 2 | - | - |
| Comparative Example 3 | 1,150 | 2,110 |

As shown in Table 2, it is determined that the total content of aluminum and tungsten, which are coating elements included in the positive electrode active material coating layers prepared in Examples 1 and 2, was in a range of 3000 ppm to 5500 ppm with respect to the total weight of the lithium composite transition metal oxide.

**- Particle size and single particle size formation degree of positive electrode active material**

Using PSA (S3500, Microtrac), an average particle size ($D_{50}$) of the positive electrode active materials prepared in Example and Comparative Example was measured, and is shown in Table 3 below.

In addition, using SEM (FEI, Inspect F), SEM images (magnification: 5 K) of the positive electrode active materials prepared in Example and Comparative Example were obtained, and using an image processing program (LG Chemical, DX program), images where primary particles present in the SEM images were segmented and colored randomly were obtained. Using the images where primary particles were segmented and colored randomly, an area of each primary particle was calculated based on the number of pixels corresponding to each of the n primary particles (on average, at least 50,000 primary particles) and an average particle size ($D'_{50}$) of primary particles present in the lithium composite transition metal oxide prepared in Example 1 was measured using the diameter of a circle having the same area as each primary particle, and the results are shown in Table 3 below. In addition, a value of the average particle size ($D'_{50}$) of the primary

particles to the average particle size ($D_{50}$) of the lithium composite transition metal oxide (single particle formation degree ($\chi$)) was calculated and shown in Table 3 below.

[Table 3]

| Item | Average particle size ($\mu$m) | | Single particle formation degree ($\chi$) |
|---|---|---|---|
| | Primary particle ($D'_{50}$) | Positive electrode active material ($D_{50}$) | |
| Example 1 | 2.49 | 4.02 | 0.62 |
| Example 2 | 3.42 | 3.89 | 0.88 |
| Comparative Example 1 | 1.58 | 4.34 | 0.36 |
| Comparative Example 2 | 2.49 | 4.02 | 0.62 |
| Comparative Example 3 | 3.73 | 4.04 | 0.92 |

As shown in Table 3, it is determined that the primary particles of the positive electrode active materials prepared in Examples 1 and 2 had an average particle size ($D'_{50}$) of 2 $\mu$m to 5 $\mu$m, and the positive electrode active materials had an average particle size ($D_{50}$) of 3 $\mu$m to 5 $\mu$m. In addition, it is determined that the positive electrode active materials prepared in Examples 1 and 2 had a single particle formation degree ($\chi$) of greater than 0.5 according to Equation 1 described herein. For reference, it is seen that the positive electrode active materials prepared in Examples 1 and 2 are in the form of a single particle in which agglomeration between primary particles is suppressed based on the fact that the single particle formation degree is in a range of 0.6 to 0.9. Meanwhile, it is determined that the positive electrode active material prepared in Comparative Example 1 has a single particle formation degree of 0.5 or less according to Equation 1 described herein.

Meanwhile, the positive active material prepared in Example 1 including a coating layer and the positive active material prepared in Comparative Example 2 not including a coating layer have an average particle size ($D'50$) of the primary particles and an average particle size ($D50$) of the positive active material that are almost identical, so it is seen that the coating layer was formed at the nano level.

**- Shape of positive electrode active material and coating layer**

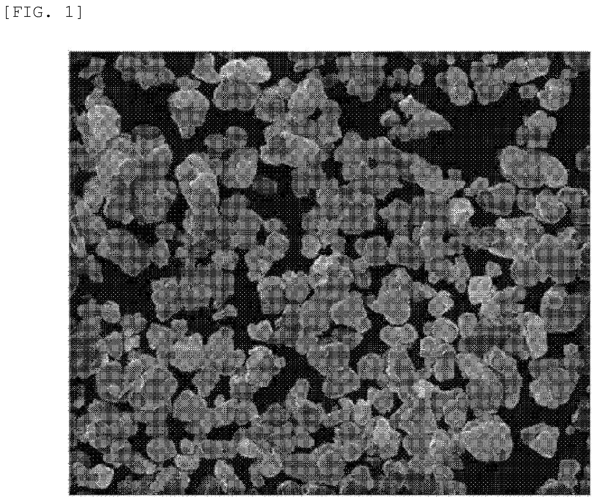

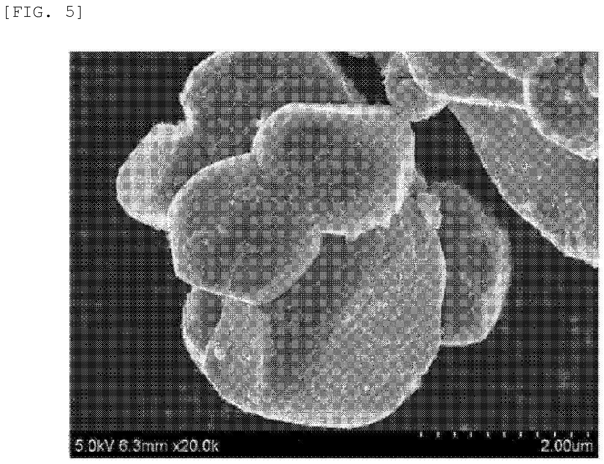

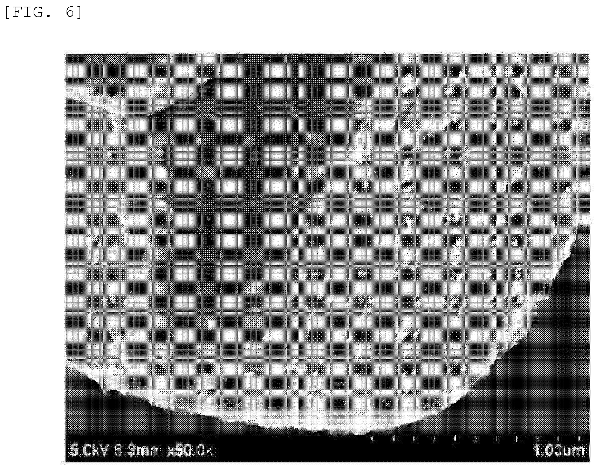

For the positive electrode active materials prepared in Examples and Comparative Examples, SEM images were obtained at a magnification of 5 K using scanning electron microscope (SEM), and the SEM images of the positive electrode active materials prepared in Examples 1 and 2 and Comparative Examples 1 and 3 are shown in FIGS. 1 to 4. In addition, for the positive electrode active material prepared in Example 1, SEM images were obtained at a magnification of 20 K and 50 K, and these are each shown in FIGS. 5 and 6.

FIG. 1 is an SEM image (magnification: 5K) showing a positive electrode active material prepared in Example 1.

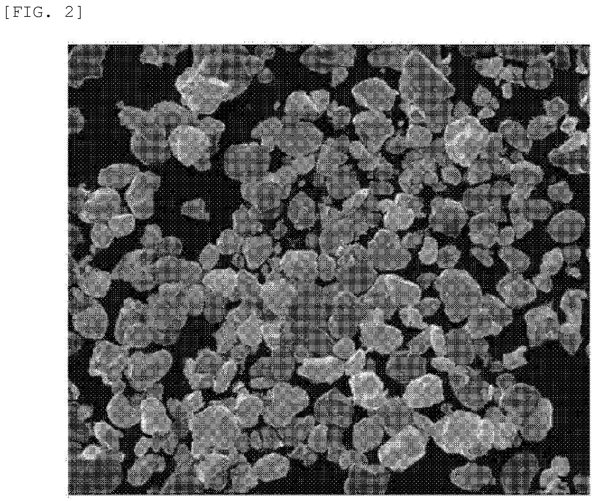

FIG. 2 is an SEM image (magnification: 5K) showing a positive electrode active material prepared in Example 2.

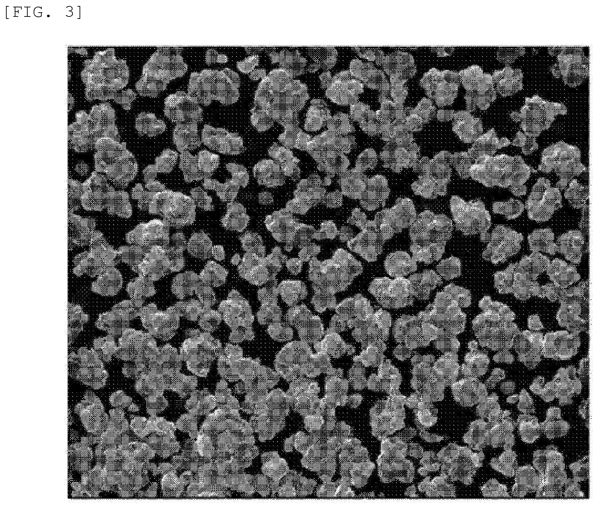

FIG. 3 is an SEM image (magnification: 5 K) showing a positive electrode active material prepared in Comparative Example 1.

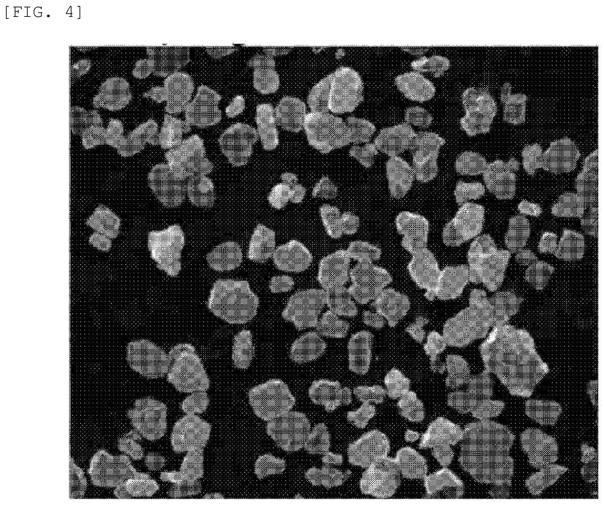

FIG. 4 is an SEM image (magnification: 5 K) showing a positive electrode active material prepared in Comparative Example 3.

FIG. 5 is an SEM image (magnification: 20 K) showing a positive electrode active material prepared in Example 1.

FIG. 6 is an SEM image (magnification: 50 K) showing a positive electrode active material prepared in Example 1.

As shown in FIGS. 1 to 4, the positive electrode active materials prepared in Examples 1 and 2 according to the present invention were found to be in the form of a single particle. The positive electrode active material is composed of a coating layer on a lithium composite transition metal oxide and a lithium composite transition metal oxide, and since it is determined in Experimental Example that the coating layer was formed at the nanoscale, it is seen that the lithium composite transition metal oxides prepared in Examples 1 and 2 are in the form of a single particle. In addition, it is determined that the positive electrode active materials prepared in Examples 1 and 2 had fewer fine particles and a larger particle size than the positive electrode active material prepared in Comparative Example 1.

As shown in FIGS. 5 and 6, it is determined that the positive electrode active material prepared in Example 1 according to the present invention included a coating layer containing a coating element as an island type on the positive electrode active material.

In conclusion, it is determined that the positive electrode active materials prepared in Examples 1 and 2 had a larger average particle size ($D'_{50}$) of primary particles than the positive electrode active material prepared in Comparative Example 1, and that the coating layer containing the coating element (M) was in the form of partially covering at least a portion on the lithium composite transition metal oxide.

**Experimental Example 3: Evaluation of battery properties**

**- Manufacturing of coin type half-cells**

A positive electrode slurry was prepared by mixing 95 wt% of each of the positive electrode active materials prepared in Examples and Comparative Examples, 2.0 wt% of Super P as a conductive material, and 3.0 wt% of polyvinylidene fluoride (PVDF) as a binder in an N-methylpyrrolidone (NMP) solvent. The prepared positive electrode slurry was applied onto one surface of an aluminum current collector, dried at 130 °C, and then rolled to prepare a positive electrode.

A lithium metal electrode was used as a negative electrode, and an electrode assembly was prepared by disposing a porous polyethylene separator between the positive electrode and the negative electrode. The electrode assembly was placed inside a battery case and an electrolyte where 1 M $LiPF_6$ was dissolved in an organic solvent in which ethylene carbonate (EC), ethyl methyl carbonate (EMC), and diethyl carbonate (DEC) were mixed in a volume ratio of 3:4:3 was injected to manufacture a coin-type half-cell.

**- Evaluation of battery capacity characteristics and cycle characteristics**

The coin type half-cells manufactured as described above were charged (0.1 C) up to 4.45 V at 25 °C in CC-CV mode, and then discharged (0.1 C) up to 2.5 V in CC mode to perform a formation process.

A cycle in which the monocell was charged (0.33 C) up to 4.45 V in CC-CV mode at 45 °C, and then discharged (0.33 C) up to 2.5 V in CC mode was considered one cycle, and a total of 100 cycles of charging and discharging were repeated, and the discharge capacity each at the first cycle and at the 100th cycle was measured, and a percentage of the discharge capacity at the 100th cycle to the discharge capacity at the first cycle (capacity retention (%)) is shown in Table 4 below.

In addition, after measuring the DC internal resistance (DCIR) of the first cycle and the DC internal resistance (DCIR) of the 100th cycle, a percentage (resistance increase rate (%)) of a DCIR value of the 100th cycle to a DCIR value of the first cycle was calculated and shown in Table 4 below. The DCIR value is calculated by dividing a difference between a voltage at 60 seconds and an initial voltage while discharging with a constant current of 0.33 C in each cycle by the applied current.

The cells were charged (0.1 C) up to 4.45 V in CC-CV mode at 25 °C, and then discharged (0.1 C) up to 2.5 V in CC mode to perform an initial charge/discharge process, and the charge and discharge capacities in this case were measured. The measured charge and discharge capacities and the percentage of discharge capacity to charge capacity (efficiency (%)) are shown in Table 4 below.

[Table 4]

| | @45 °C, 0.33 C | | | @45 °C, 0.33 C | | | @25 °C, 0.1 C | | |
|---|---|---|---|---|---|---|---|---|---|
| | Discharge capacity (mAh/g) | | Capacity Retention rate (%) | DC internal resistance (DCIR) | | Resistance Increase rate (%) | Charge capacity (mAh/g) | Discharge capacity (mAh/g) | Efficiency (%) |
| | 1st cycle | 100th cycle | | 1st cycle | 100th cycle | | | | |
| Example 1 | 186.0 | 168.8 | 89.5 | 1.50 | 3.20 | 113.5 | 222.4 | 201.4 | 90.6 |
| Example 2 | 184.6 | 168.2 | 91.1 | 1.61 | 3.59 | 122.7 | 221.4 | 199.8 | 90.2 |
| Comparative Example 1 | 190.4 | 169.5 | 89.0 | 1.46 | 3.54 | 142.3 | 224.2 | 203.1 | 90.6 |
| Comparative Example 2 | 183.4 | 161.4 | 88.0 | 1.68 | 4.41 | 162.4 | 221.2 | 198.8 | 89.8 |
| Comparative Example 3 | 187.2 | 171.3 | 91.5 | 2.24 | 5.45 | 143.3 | 224.0 | 200.6 | 89.6 |

As shown in Table 4, the battery including the positive electrode active material prepared in Comparative Example 1 having a degree of single particle formation of 0.5 or less according to Equation 1 described herein had a high discharge capacity at the first cycle and the 100th cycle at high temperatures, and high charge/discharge capacity and efficiency at room temperature, but exhibited low capacity retention and high resistance increase rate at high temperatures. Meanwhile, the battery including the positive electrode active material prepared in Comparative Example 2 not including a coating layer on the lithium composite transition metal oxide had low discharge capacity, capacity retention, and efficiency at the first cycle and the 100th cycle at high temperatures, high resistance increase rate, and low charge/discharge capacity and efficiency at room temperature.

In addition, the battery including the positive electrode active material prepared in Comparative Example 3, in which the lithium composite transition metal oxide does not have the composition represented by Formula 1 described herein, specifically a-c is greater than 0.45, had high charge/discharge capacity and capacity retention at high temperatures, but exhibited high temperature DC internal resistance and high resistance increase rate, and low charge/discharge efficiency at room temperature.

In comparison, it is determined that the battery including the positive electrode active materials prepared in Examples 1 and 2, in which the degree of single particle formation according to Equation 1 described herein is greater than 0.5, maintained the charge/discharge capacity at high temperatures and the charge/discharge capacity and efficiency at room temperature at the same level as the battery including the positive electrode active material prepared in Comparative Example 1, but exhibited excellent capacity retention and resistance increase rate at high temperatures. In addition, Examples 1 and 2 included a coating layer including a coating element (M) on a lithium composite transition metal oxide, thereby showing that the discharge capacity and capacity retention, efficiency, and resistance increase rate at high temperatures at the first cycle and 100th cycle were all superior to those of the battery including the positive electrode active material prepared in Comparative Example 2, and it is determined that the battery including the positive electrode active materials prepared in Examples 1 and 2 having a composition represented by Formula 1 described herein maintained the capacity retention at high temperatures at a similar level to that of the battery manufactured in Comparative Example 3, but showed superior resistance and resistance increase rate at high temperatures and superior charge/discharge efficiency at room temperature.

In conclusion, it is determined that the positive electrode active material according to the present invention maintains charge/discharge capacity and efficiency at high temperatures and room temperature at equivalent levels, while also exhibiting excellent DC internal resistance and resistance increase rate at high temperatures. Accordingly, it is seen that the positive electrode active material according to the present invention maintains energy density and is stable with little structural change even during charge/discharge cycles.

**Claims**

1. A positive electrode active material comprising:

   a lithium composite transition metal oxide in the form of a single particle formed of 10 or fewer primary particles, having a composition represented by Formula 1 below; and
   a coating layer comprising a coating element (M) formed on the lithium composite transition metal oxide,
   wherein the coating element (M) is at least one selected from Al, W, Cu, Zr, Ni, Co, Sr, Mn, Y, Ti, Mg, Mo, B, Sn, Fe, Zn, and Si, and
   a single particle formation degree ($\chi$) is greater than 0.5 according to Equation 1 below:

   $$[\text{Formula 1}] \qquad Li_{1+x}Ni_aCo_bMn_cM^1_cO_2$$

   wherein in Formula 1 above,
   $M^1$ is at least one selected from Zr, Y, W, Cu, Sr, Mn, Ti, Mg, Mo, B, Sn, Fe, Zn, Si, and Al,
   x, a, b, c, and d satisfy $-0.1 \leq x \leq 0.1$, $0.6 \leq a < 1$, $0 < b < 0.4$, $0 < c < 0.4$, $0 \leq d \leq 0.1$, $a+b+c+d=1$, and $0.25 \leq a-c \leq 0.45$, and

   $$[\text{Equation 1}]$$

   $$\chi = \frac{\text{Average particle size of primary particle } (D'_{50}) [\mu m]}{\text{Average particle size of positive electrode active material } (D_{50}) [\mu m]}.$$

2. The positive electrode active material of claim 1, wherein in Formula 1 above, a ranges from 0.6 to 0.75.

3. The positive electrode active material of claim 1, wherein in Formula 1 above, a-c satisfies $0.25 < a-c < 0.34$.

4. The positive electrode active material of claim 1, wherein the coating layer contains the coating element (M) in an amount of 3000 ppm to 5500 ppm with respect to a total weight of the lithium composite transition metal oxide.

5. The positive electrode active material of claim 1, wherein the coating layer comprises a Li-M-O compound, and M is at least one selected from Al, W, Cu, Zr, Ni, Co, Sr, Mn, Y, Ti, Mg, Mo, B, Sn, Fe, Zn, and Si.

6. The positive electrode active material of claim 1, wherein the coating element (M) is at least one selected from Al and W.

7. The positive electrode active material of claim 1, wherein the primary particles have an average particle size ($D'_{50}$) of 2 $\mu$m to 5 $\mu$m.

8. The positive electrode active material of claim 1, wherein the positive electrode active material has an average particle size ($D_{50}$) of 3 $\mu$m to 5 $\mu$m.

9. The positive electrode active material of claim 1, wherein the single particle formation degree ($\chi$) ranges from 0.6 to 0.9.

10. A method for preparing the positive electrode active material according to claim 1, the method comprising:

    (A) mixing and firing a composite transition metal hydroxide and a lithium (Li)-containing raw material to prepare a lithium composite transition metal oxide; and
    (B) mixing the lithium composite transition metal oxide and a coating element (M)-containing raw material and then heat treating the mixture to form a coating layer,
    wherein the firing is performed at a temperature of 800 °C to 1100 °C, and
    the coating element (M) is at least one selected from Al, W, Cu, Zr, Ni, Co, Sr, Mn, Y, Ti, Mg, Mo, B, Sn, Fe, Zn, and Si.

11. The method of claim 10, wherein the coating element (M)-containing raw material is at least one selected from oxide, carbonate, nitrate, hydroxide, oxyhydroxide, and halide, containing the coating element (M).

12. The method of claim 10, wherein the coating element (M)-containing raw material is mixed to achieve the coating element (M) in an amount of 3000 ppm to 5500 ppm with respect to a total weight of the lithium composite transition metal oxide.

13. The method of claim 10, wherein the heat treatment is performed at a temperature of 400 °C to 600 °C.

14. A positive electrode comprising the positive electrode active material according to any one of claims 1 to 9.

15. A lithium secondary battery comprising the positive electrode according to claim 14.

[FIG. 1]

[FIG. 2]

[FIG. 3]

[FIG. 4]

[FIG. 5]

[FIG. 6]

## INTERNATIONAL SEARCH REPORT

| International application No. |
|---|
| **PCT/KR2024/096452** |

| A. | CLASSIFICATION OF SUBJECT MATTER |
|---|---|

**H01M 4/36**(2006.01)i; **H01M 4/525**(2010.01)i; **H01M 4/505**(2010.01)i; **C01G 53/00**(2006.01)i; **H01M 4/131**(2010.01)i; **H01M 10/052**(2010.01)i; **H01M 4/02**(2006.01)i

According to International Patent Classification (IPC) or to both national classification and IPC

| B. | FIELDS SEARCHED |
|---|---|

Minimum documentation searched (classification system followed by classification symbols)

H01M 4/36(2006.01); H01M 10/052(2010.01); H01M 4/525(2010.01); H01M 4/66(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal), STN (Registry, Caplus), Google & keywords: 리튬 이차 전지 (lithium secondary battery), 양극 활물질 (cathode active material), 리튬 복합 전이금속 산화물 (lithium complex transition metal oxide), 단입자화도 (single particle degree)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | KR 10-2018-0059736 A (POSCO et al.) 05 June 2018 (2018-06-05)<br>See claims 1, 3, 7, 9, 13 and 14; and paragraphs [0024], [0028], [0036] and [0051]-[0064]. | 1,2,4,6-10,12-15 |
| Y | | 3,5,11 |
| Y | YE, T. et al. Magnetic frustration effect on the rate performance of LiNi0.6Co0.4-xMnxO2 cathodes for lithium-ion batteries. Advanced Energy Materials. 2022, vol. 12, article no. 2201556, pp. 1-12.<br>See pages 2 and 10. | 3 |
| Y | KR 10-2016-0090580 A (SAMSUNG SDI CO., LTD.) 01 August 2016 (2016-08-01)<br>See claims 1, 2 and 6; and paragraph [0047]. | 5,11 |
| A | KR 10-2023-0107145 A (LG ENERGY SOLUTION, LTD.) 14 July 2023 (2023-07-14)<br>See claim 1. | 1-15 |

| ✓ | Further documents are listed in the continuation of Box C. | ✓ | See patent family annex. |
|---|---|---|---|

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **10 February 2025** | **10 February 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT

International application No.

**PCT/KR2024/096452**

### C. DOCUMENTS CONSIDERED TO BE RELEVANT

| Category* | Citation of document, with indication, where appropriate, of the relevant passages | Relevant to claim No. |
|---|---|---|
| A | JP 2015-118939 A (ROBERT BOSCH GMBH) 25 June 2015 (2015-06-25)<br>  See claims 1-4. | 1-15 |

Form PCT/ISA/210 (second sheet) (July 2022)

**INTERNATIONAL SEARCH REPORT**
Information on patent family members

International application No.

**PCT/KR2024/096452**

| Patent document cited in search report | | | Publication date (day/month/year) | Patent family member(s) | | | Publication date (day/month/year) |
|---|---|---|---|---|---|---|---|
| KR | 10-2018-0059736 | A | 05 June 2018 | KR | 10-2017-0076348 | A | 04 July 2017 |
| | | | | KR | 10-2295296 | B1 | 27 August 2021 |
| KR | 10-2016-0090580 | A | 01 August 2016 | US | 2016-0218359 | A1 | 28 July 2016 |
| KR | 10-2023-0107145 | A | 14 July 2023 | CN | 118511323 | A | 16 August 2024 |
| | | | | EP | 4443563 | A1 | 09 October 2024 |
| | | | | JP | 2024-545475 | A | 06 December 2024 |
| | | | | US | 2023-0223526 | A1 | 13 July 2023 |
| | | | | WO | 2023-132685 | A1 | 13 July 2023 |
| JP | 2015-118939 | A | 25 June 2015 | DE | 102013226011 | A1 | 18 June 2015 |
| | | | | US | 2015-0171427 | A1 | 18 June 2015 |
| | | | | US | 9819011 | B2 | 14 November 2017 |

Form PCT/ISA/210 (patent family annex) (July 2022)

**REFERENCES CITED IN THE DESCRIPTION**

**Patent documents cited in the description**

- KR 1020230151121
- KR 1020210007808